# EUROPEAN PATENT APPLICATION

(11) **EP 0 536 416 A1**
(43) Date of publication of application: **14.04.1993**
(21) Application number: 92909480.3
(22) Date of filing: 23.04.1992
(51) Int. Cl.: G09G 5/06, G06F 3/153, G06F 15/66, G06F 15/68, H03M 1/74, H03M 1/08, H03M 1/10

(54) **DATA PROCESSOR**

(30) Priority: 24.04.1991 JP 94157/91; 24.04.1991 JP 94162/91
(71) Applicant: SEIKO EPSON CORPORATION, Shinjuku-ku Tokyo 163 (JP)
(72) Inventor: NAKAMURA, Katsutoshi, Nagano 392 (JP)
(74) Representative: Burke, Steven David
(86) International application number: JP9200530
(87) International publication number: WO9220062

(57) **Abstract**

A data processor for display comprising a color data processor for image processing using a color conversion table, and a digital-to-analog converter which converts digital image data into video signals for display on a CRT. The data processor includes an image data storage unit which stores image data as color numbers, a color conversion table storage unit which stores data corresponding to color numbers and outputs to the display unit the color data that correspond to color numbers read out from the image data storage unit, a temporary storage unit for temporarily storing rewrite data consisting of pairs of rewrite color data and rewrite color numbers for rewriting color data stored in the color conversion table storage unit, and a color conversion table rewriting unit which rewrites color data in the color conversion table storage unit based on a preceding rewrite data stored in the temporary storage means.

## Description

### Technical Field

The present invention relates to a data processing apparatus for displaying image information in an information processing system and, more particularly, to a color information processing apparatus for processing image information by using a color conversion table, a digital-to-analog converter for converting the image information as a digital value into a video signal in order to display the image information on a CRT or the like, and a data processing apparatus using these color information processing apparatus and digital-to-analog converter.

### Background Art

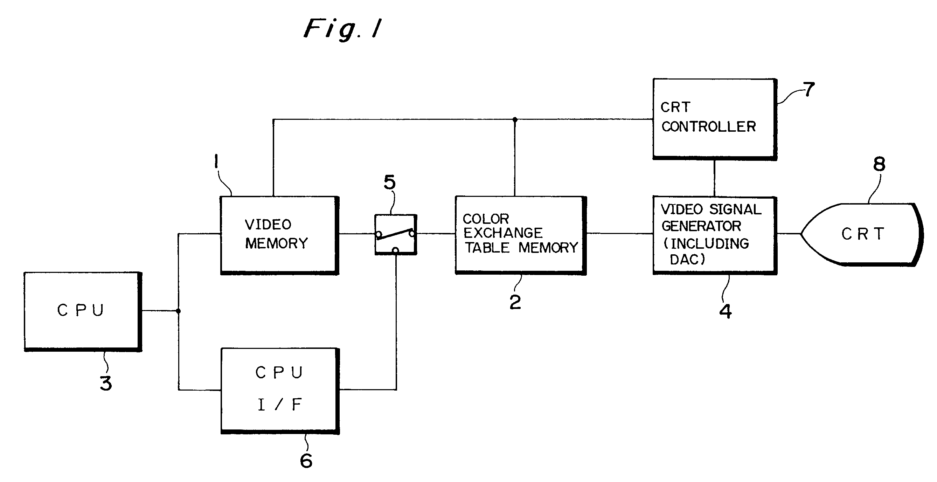

Fig. 1 shows an arrangement of a conventional information display apparatus of the above type. Input information are stored as color numbers in a video memory 1, and color data corresponding to these color numbers are stored in a color conversion table memory 2. Under the control of a CPU 3, a specific color number is designated and read out from the video memory 1, and color data corresponding to the readout color number is output from the color conversion table memory 2. A raster scan type video display consisting of a CRT 8 causes a video signal generator 4 to perform digital-to-analog conversion for the output color data from the color conversion table memory 2. Image display is performed on the basis of this analog-converted video signal. A CRT controller 7 supplies a clock signal, a blanking signal, and the like for controlling the image display. In order to allow different color data to correspond to a color number stored in the video memory 1, a table constant in the color conversion table memory 2 must be rewritten. To perform this rewriting, the CPU 3 switches the connection of a bus switch 5 from the video memory 1 to a CPU I/F 6 and accesses the color conversion table memory 2 via the I/F 6, thereby rewriting the table information.

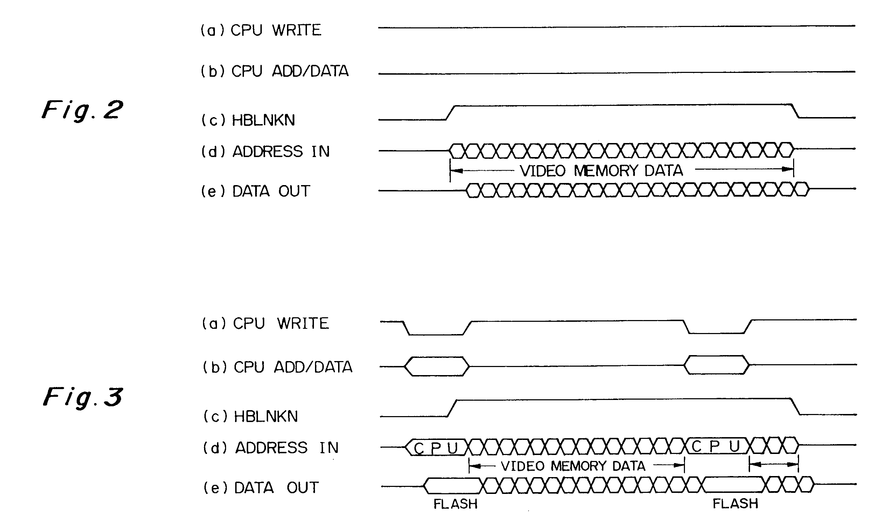

Fig. 2 shows a timing chart for explaining signals of the individual parts of this information display apparatus in normal operation. A signal (a) in Fig. 2 shows the timing of a write signal (CPU WRITE) of the CPU 3. This signal is at level HIGH all the time, indicating that no access is made from the CPU 3 to the color conversion table memory 2. A signal (b) in Fig. 2 indicates the timing of a signal (CPU ADD./DATA) on an address bus and a data bus from the CPU I/F 6 to the bus switch 5. The signal (b) is not generated at all during the entire operation; this signal is new rewrite information for changing the table constant of the color conversion table memory 2. A signal (c) in Fig. 2 shows the timing of a blanking signal (HBLNKN) output from the CRT controller 7 to the color conversion table memory 2 during the retrace interval of a horizontal sync signal.

A signal (d) in Fig. 2 indicates the timing of an address signal (ADDRESS IN) input to the color conversion table memory 2. This address signal is data stored in the video memory 1 and generated in correspondence with HIGH of the HBLNKN signal. A signal (e) in Fig. 2 shows the timing of a data signal (DATA OUT) output from the color conversion table memory 2. This data signal is generated to slightly lag behind the ADDRESS IN signal. The CRT 8 performs image display on the basis of a video signal obtained by performing digital-to-analog conversion for this DATA OUT signal.

Bt453 available from Brooktree Corporation is an example of a device in which the color conversion table memory and the digital-to-analog converter of the above type are fabricated on a single chip.

In the above conventional information display apparatus, however, the CPU 3 and the video signal generator 4 generally operate asynchronously from each other. This introduces the following problem in changing the color data stored in the color conversion table memory 2.

That is, if the CPU 3 unconditionally switches the bus switch 5 to disconnect the video memory 1 from the color conversion table memory 2 in order to access the color conversion table memory 2, information stored in the video memory 1 is not displayed any longer on the screen of the CRT 8 during this access period. In addition, noise (flash), which is not original display information, is displayed on the screen.

This problem will be described below with reference to a flow chart shown in Fig. 3. When a CPU WRITE signal indicated by a signal (a) in Fig. 3 changes its state as shown in Fig. 3, the CPU 3 outputs a CPU ADD./DATA signal indicated by a signal (b) in Fig. 3 in correspondence with LOW of the CPU WRITE signal. And an HBLNKN signal indicating a retrace interval is generated at the timing indicated by a signal (c) in Fig. 3. At this time, an ADDRESS IN signal to be supplied to the color conversion table memory 2 via the bus switch 5 is generated at the timing indicated by a signal (d) in Fig. 3. That is, when the CPU WRITE signal is at level LOW, the bus switch 5 is connected to the CPU I/F 6 side, and the CPU ADD./DATA signal is supplied to the color conversion table memory 2; when the CPU WRITE signal is at level HIGH, the bus switch 5 is connected to the video memory 1 side, and video memory data (VIDEO MEMORY DATA) stored in the video memory 1 is supplied to the color conversion table memory 2. An output DATA OUT signal from the color conversion table memory 2 is indicated by a signal (e) in Fig. 3; the signal slightly lags in timing behind the ADDRESS IN signal. When the HBLNKN signal is at level HIGH, therefore, the video memory 1 and the color conversion table memory 2 are disconnected from each other, and the CPU ADD./DATA signal is undesirably output to the color conversion table memory 2. This consequently produces flash (FLASH) during a period of the DATA OUT signal corresponding to the CPU ADD./DATA signal.

In order to eliminate such flash, it is possible to make use of a scheme in which information rewriting into the color conversion table memory 2 is not performed during the display time of the CRT 8 but performed after that.

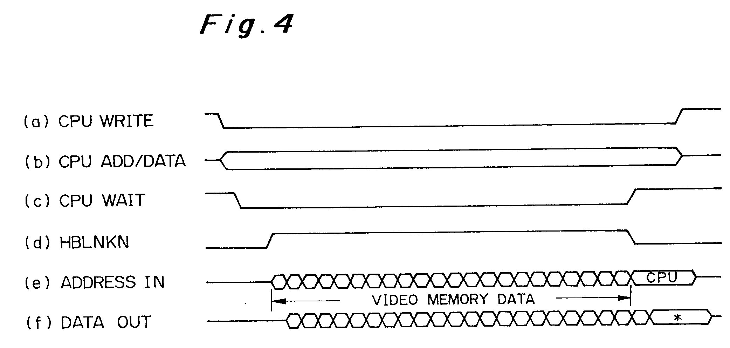

A practical example of this scheme will be described below with reference to a timing chart shown in Fig. 4. Referring to Fig. 4, a CPU WRITE signal goes LOW at a timing indicated by a signal (a) in Fig. 4, and a CPU ADD./DATA signal is output at a timing indicated by a signal (b) in Fig. 4 in correspondence with this LOW period. An HBLNKN signal goes HIGH as indicated by a signal (d) in Fig. 4 in correspondence with LOW of the CPU WRITE signal, so write processing for the color conversion table memory 2 is executed during the display time of the CRT 8. Therefore, in order to cause the write processing performed by the CPU 3 to wait, a CPU WAIT signal indicated by a signal (c) in Fig. 4 is set at LOW to delay the information write processing by the CPU 3. As a result, an ADDRESS IN signal indicated by a signal (e) in Fig. 4 is supplied as video memory data from the video memory 1 to the color conversion table memory 2 during the HIGH period of the HBLNKN signal. For this reason, a DATA OUT signal indicated by a signal (f) in Fig. 4 is output as video memory data in correspondence with the display time of the CRT 8. The write processing by the CPU 3 with respect to the color conversion table memory 2 waits until the HBLNKN signal goes LOW in accordance with the CPU WAIT signal; the information rewriting is performed into the color conversion table memory 2 during a retrace interval indicated by a symbol "*" of the signal (f) in Fig. 4. This eliminates occurrence of flash on the screen.

If, however, flash is eliminated by the use of this scheme, the CPU 3 temporarily stops until the display time elapses; this decreases the practical operating speed of the CPU 3. As a result, the speed of the information display processing decreases.

As means for eliminating flash, it is also possible to use a dual port memory capable of write and read operations independently of each other as the color conversion table memory 2. However, the storage capacity of the dual port memory is commonly small, so the dual port memory cannot be used in storing a large amount of color data into a color conversion table. Also, even if a large-capacity dual port memory is possible, the resulting apparatus becomes expensive.

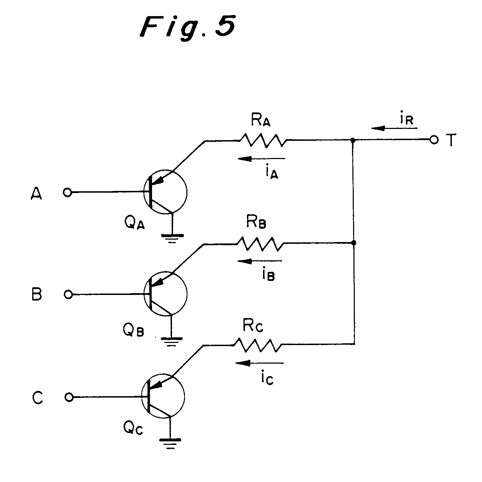

The output data signal from the color conversion table memory 2 is converted into an analog video signal by the digital-to-analog converter (DAC) and then transferred to the CRT. Conventionally, a 3-bit DAC having a circuit configuration as shown in Fig. 5, for example, is used as the DAC for this purpose. The DAC shown in Fig. 5 comprises three bipolar transistors Q_{A}, Q_{B}, and Q_{C}. The emitter of each transistor is connected to one end of a corresponding one of resistors R_{A}, R_{B}, and R_{C}, and the other ends of these resistors are connected together to an analog output terminal T. The collector of each transistor is grounded. The resistance of the resistor R_{A} is smallest of the three, the resistance of the resistor R_{B} is higher than the resistor R_{A}, and the resistance of the resistor R_{C} is higher than the resistor R_{B} (R_{A} < R_{B} < R_{C}). Therefore, a largest current is flowed through the transistor Q_{A}, and currents flowing through the transistors Q_{B} and Q_{C} are decreased in this order.

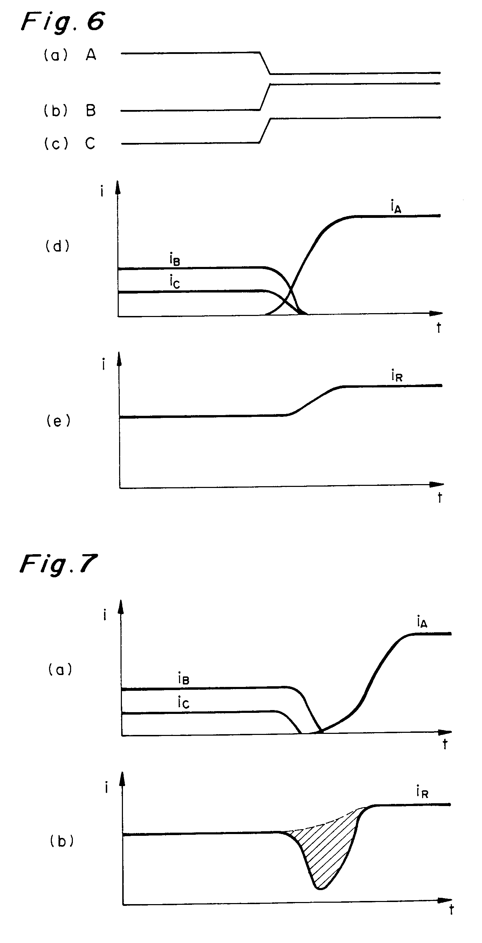

In this arrangement, when digital signals A, B, and C indicated by signals (a), (b), and (c) in Fig. 6 are input to the bases of the transistors Q_{A}, Q_{B}, and Q_{C}, respectively, currents i_{A}, i_{B}, and i_{C} presented by a graph (d) in Fig. 6 flow through the transistors Q_{A}, Q_{B}, and Q_{C}, respectively. As a result, a current i_{R} given by a graph (e) in Fig. 6 corresponding to the sum of these currents appears at the analog output terminal T. This current i_{R} has an analog quantity corresponding to the input digital signals; D/A conversion has been performed by the operations of the transistors Q_{A}, Q_{B}, and Q_{C} corresponding to the input digital signals. Note that in each of the graphs (d) and (e) of Fig. 6, the ordinate represents current i, and the abscissa represents time t.

The above conventional DAC, however, has the following problems.

First, the currents i_{A}, i_{B}, and i_{C} for determining the analog output vary due to changes in resistances. To eliminate this drawback to accurately output an analog quantity corresponding to the input digital signals, the resistors R_{A}, R_{B}, and R_{C} must have high precisions in their respective resistances. The currents i_{A}, i_{B}, and i_{C} are susceptible not only to the influence of the resistances of the resistors R_{A}, R_{B}, and R_{C} but also to that of the internal resistances of the transistors Q_{A}, Q_{B}, and Q_{C}. In addition, a wiring resistance changes due to changes in positions of the individual transistors on a semiconductor chip, and the currents i_{A}, i_{B}, and i_{C} are also influenced by this resistance change. For these reasons, it is conventionally difficult to perform accurate D/A conversion due to these changes in individual resistances. The precision in D/A conversion decreases especially when the number of bits to be converted increases.

The second problem is transient noise produced in an analog output due to a difference in operating speed between the transistors Q_{A}, Q_{B}, and Q_{C}. For example, in the DAC shown in Fig. 5, if the operation of the transistor Q_{A} for flowing a large current delays, the waveforms of the currents i_{A}, i_{B}, and i_{C} to be flowed through these transistors become those given by a graph (a) in Fig. 7; the leading edge of the current i_{A} delays. In this case, the current i_{R} appearing as the sum of these currents at the analog output terminal T becomes as presented by a graph (b) in Fig. 7. In the graph (b) of Fig. 7, a spike represented by a hatched portion is a glitch, indicating that transient noise occurs in an analog output. Such a glitch is liable to occur especially when the input digital signals A, B, and C change from 1, 0, 0 to 0, 1, 1. Originally, an output waveform indicated by a broken line in the graph (b) is desirable. To obtain such an output in this conventional DAC, however, the transistors must be so fabricated as to have the same operating speed.

Third, in order to weight division of the analog output, bipolar transistors having a current capacity to some extent are required as the transistors for dividing the analog output. This makes it impossible to use MOS transistors, which are inexpensive, have high packing densities, and consume little power.

### Disclosure of Invention

The present invention has been made to solve the above problems and has as its object to provide an information display apparatus having a high speed in information display processing, free from flash, and inexpensive, and an information processing system using this information display apparatus.

For this purpose, the present invention comprises display means for performing image display by a raster scan scheme, image information storage means for storing image information as color numbers, color conversion table storage means for storing color data corresponding to the color numbers and outputting color data corresponding to a color number read out from the image information storage means to the display means, temporary storage means for temporarily storing rewrite information as a pair of a rewrite color number and rewrite color data for rewriting the color data stored in the color conversion table storage means, and color conversion table rewriting means for rewriting the color data in said color conversion table storage means within a blanking interval of the display means in accordance with the rewrite information stored in the temporary storage means.

Compared to conventional systems, the present invention is characterized by comprising a buffer for temporarily storing the rewrite information as a pair of a color number and new color data for rewriting the color data stored in the color conversion table storage means, and the table information rewriting means for writing the new color data, which is temporarily stored in the buffer, into a location corresponding to a designated color number in the color conversion table storage means within the blanking interval of the display means.

Since the buffer temporarily stores the rewrite information as a pair of the color number and the new color data, a CPU can perform write processing at an arbitrary timing. In addition, the rewrite information as a pair of a new color number and new color data written in the buffer are read out to change the contents of the color conversion table storage means within the blanking interval of the display means. Hence, there is provided a color information processing apparatus having a high speed in information display processing, free from flash, and inexpensive.

Also, the present invention is a digital-to-analog converter for digital-to-analog-converting color data, as a digital value output from the color conversion table storage means to the display means, into a video signal, comprising output means in which a plurality of switches are commonly connected in parallel with a common output terminal, and switch control means for controlling the switches, wherein each switch has an element for controlling a current flowing through the switch in correspondence with ON/OFF, and the switch control means controls in correspondence with the input digital value so as to turn on OFF switches without turning off ON switches when the number of ON switches is to be increased, and to turn off ON switches without turning on OFF switches when the number of ON switches is to be decreased.

In this case, the values of currents flowing through ON switches substantially equal each other. The switch control means includes a decoder unit, having a plurality of decoder output terminals, for outputting a signal to one of the decoder output terminals in correspondence with an input digital value, and a logic circuit, having logic circuit output terminals in a number equal to the number of the switches, for outputting signals to the logic circuit output terminals in a number corresponding to the number of the decoder output terminals.

An analog output is equally divided by the switches constituting the output means. The analog quantities thus divided equally, i.e., the outputs from the individual switches are integrated and converted into an analog output corresponding to the input digital values. Therefore, even if each divisional quantity varies more or less due to a variation in resistance or the like, a variation in sum total of variations in the outputs from the switches is extremely small, so the variation in analog output corresponding to the sum total of the outputs from the switches is also very small. This enables accurate D/A conversion and prevents reduction in precision of the D/A conversion even if the number of bits to be converted increases.

In addition, the switches operate under the control such that when the number of ON switches is to be increased, OFF switches are turned on without turning off ON switches, thereby increasing the number of ON switches, and, when the number of ON switches is to be decreased, ON switches are turned off without turning on OFF switches, thereby decreasing the number of ON switches, and the outputs from the individual switches are integrated to obtain an analog output. Therefore, even if the operations of the switches more or less delay, there are neither a large increase nor a large decrease in sum total of the outputs from the switches, i.e., in analog output. This prevents occurrence of a glitch in the analog output, resulting in a DAC excellent in high-speed performance. This also makes it unnecessary to take special care in fabrication of switches in order to prevent a glitch.

Furthermore, since the analog output is equally divided, a divisional analog quantity that each switch bears, i.e., an output from each switch is small. This enables the use of a MOS transistor as each switch.

The present invention is also an information processing system, in which the output means, the switch control means, the color conversion table storage means, the temporary storage means, and the color conversion table rewriting means are formed on a single semiconductor chip, and which further comprises a CPU. Consequently, there is provided an information processing system using the color information processing apparatus and the digital-to-analog converter, which are excellent in operating speed of information display processing, free from flash, and inexpensive.

### Brief Description of Drawings

Fig. 1 is a block diagram showing the arrangement of a conventional information display apparatus;
Fig. 2 is a timing chart showing signals of individual parts of the conventional information display apparatus in normal operation;
Fig. 3 is a timing chart for explaining a problem occurring when a color conversion table memory is unconditionally accessed in the conventional information display apparatus;
Fig. 4 is a timing chart for explaining a problem occurring when a CPU accesses the color conversion table memory after the elapse of a display time in the conventional information display apparatus;
Fig. 5 is a circuit diagram showing a DAC having a conventional arrangement;
Fig. 6 is a timing chart showing an example of an ideal operation in the conventional DAC;
Fig. 7 is a timing chart for explaining one of problems in the conventional DAC;
Fig. 8 is a block diagram showing the overall arrangement of an information display apparatus according to an embodiment of the present invention;
Fig. 9 is a block diagram showing the internal arrangement of a transmission path selecting circuit in the information display apparatus according to the embodiment of the present invention;
Fig. 10 is a timing chart showing signals of individual parts of the information display apparatus of the embodiment;
Fig. 11 is a circuit diagram showing a DAC according to the embodiment of the present invention;
Fig. 12 is a timing chart showing examples of signal waveforms of individual parts of the DAC shown in Fig. 11; and
Fig. 13 is a view showing output signals from switch control means corresponding to input digital signals in the embodiment of the present invention.

### Best Mode of Carrying Out the Invention

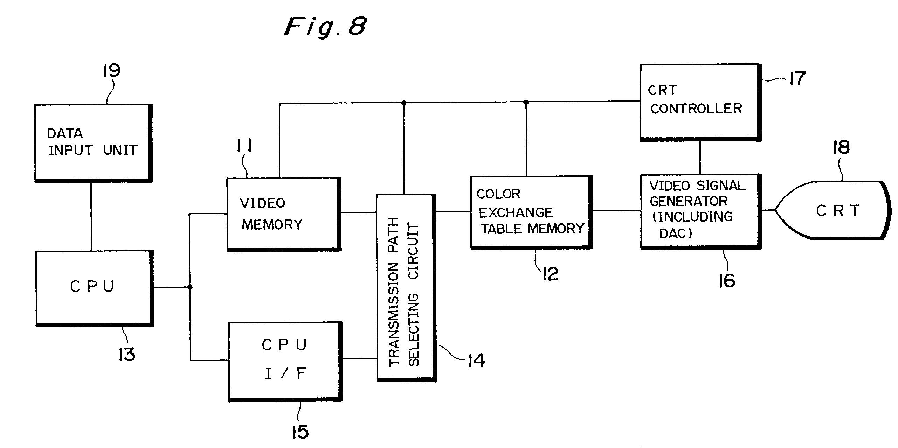

Fig. 8 is a block diagram showing the overall arrangement of an information display apparatus according to an embodiment of the present invention. This information display apparatus is for use in an information processing system, such as a personal computer, and displays various information.

Input data from a data input unit 19, such as a keyboard, is processed by a CPU 13. The CPU 13 generates image information of one screen to be displayed on a CRT 18 (to be described later) and applies the information to a video memory 11. This image information consists of color numbers in minimum units of image display.

The video memory 11 is constituted by a RAM capable of a high-speed operation and stores color numbers. A color conversion table memory 12 is also constituted by a RAM capable of a high-speed operation and stores various color data corresponding to the color numbers stored in the video memory 11. The color data are provided in a one-to-one correspondence with the color numbers stored in the video memory 11 such that, for example, red for color number 0, blue for color number 1, white for color number 2, and so on, thereby constituting a color conversion table.

Of the image information (a plurality of color numbers) stored, the video memory 11 outputs, as a color number, image information of a portion required to be displayed by a CRT controller 17 to a transmission path selecting circuit 14. To rewrite the table information stored in the color conversion table memory 12, the CPU 13 outputs a designated color number and new color data to the transmission path selecting circuit 14 via a CPU I/F circuit 15.

The transmission path selecting circuit 14 has a function of selecting information from the video memory 11 or information from the CPU I/F circuit 15 as information to be transmitted to the color conversion table memory 12, and a function of temporarily storing output information from the CPU I/F circuit 15, under the control of the CPU 13 and the CRT controller 17. The transmission path selecting circuit 14 normally connects the video memory 11 to the color conversion table memory 12, so the color conversion table memory 12 supplies color data corresponding to an output color number from the video memory 11 to a video signal generator 16. The CRT 18 is a raster scan type image display; the CRT 18 causes the video signal generator 16 to convert the color data supplied from the color conversion table memory 12 into a video signal and performs image display on the basis of this signal. To change the table information, rewrite information, which is a pair of the designated color number and the new color data stored temporarily in the transmission path selecting circuit 14, is read out within a blanking interval. At the same time, the transmission path selecting circuit 14 connects the CPU I/F circuit 15 to the color conversion table memory 12. A predetermined address, i.e., a color number of the color conversion table memory 12 is designated on the basis of the readout rewrite information, and the new color data is set.

The above arrangement will be described in more detail below. For simplicity, assume that the output from the video memory 11, i.e., the color number consists of three bits, and the output from the color conversion table memory 12, i.e., the color data also consists of three bits, Red, Green, and Blue. Therefore, available color numbers are eight from 0 to 7, and available color data are 512 colors from (0,0,0) to (7,7,7), each in an order of (R,G,B).

A color displayed on the CRT 18 is "red" for color data (7,0,0), and "green" for color data (0,7,0). For example, a one-to-one correspondence is made such that "red" for color number 0, "blue" for color number 1, "white" for color number 2,..., "black" for color number 7. In this case, (7,0,0), (0,0,7), (4,4,4),..., (0,0,0) are stored in addresses 0, 1, 2,..., 7 of the color conversion table memory 12. Note that the color numbers correspond to the address numbers of the memory.

Assume that when CRT display is performed, the video memory 11 supplies the color number 0 to the color conversion table memory 12 via the transmission path selecting circuit 14 under the control of the CRT controller 17. This color number is converted into the color data (7,0,0) and supplied to the video signal generator 16. The video signal generator 16 D/A-converts the input color data into a video signal and thereby displays "red" on the CRT 18.

Assume also that the color corresponding to the color number 0 is to be changed from "red" to "green". The CPU 13 outputs a change instruction and rewrite information as a pair of the color number 0 and the color data (0,7,0). This rewrite information containing the color number 0 and the color data (0,7,0) is temporarily stored in the transmission path selecting circuit 14 via the CPU I/F 15. Thereafter, when a blanking interval starts, the rewrite information of the color number 0 and the color data (0,7,0) stored temporarily is supplied to the color conversion table memory 12. As a result, data at address 0 of the color conversion table memory 12 is changed from (7,0,0) to (0,7,0). When the CRT display is performed after the change, "green" is displayed on the CRT 18 for the color number 0.

The details of the circuits will be described below.

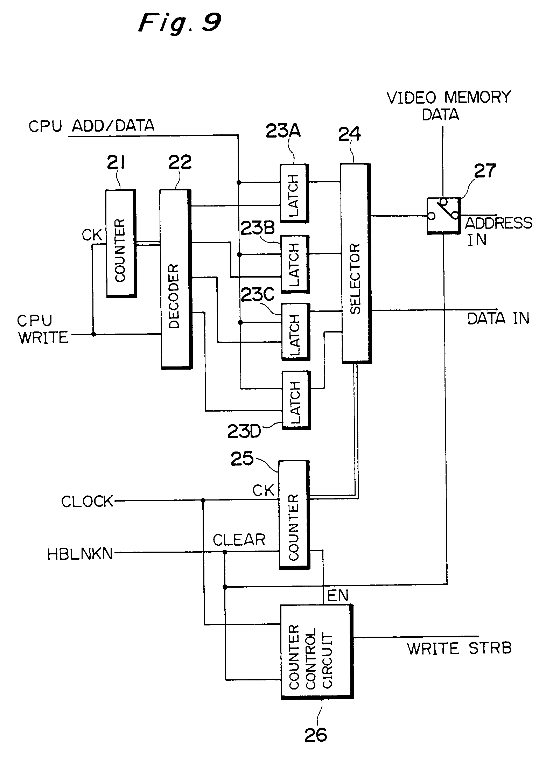

Fig. 9 is a block diagram showing the internal arrangement of the transmission path selecting circuit 14, which is constituted by a buffer and a table information rewriting circuit. A counter 21, a decoder 22, and latch circuits 23A to 23D constitute a buffer for temporarily storing rewrite information, which is a pair of a designated color number and new color data for rewriting color data stored in the color conversion table memory 12. A selector 24, a counter 25, a counter control circuit 26, and a bus switch 27 constitute table information rewriting means for writing new color data in the color conversion table memory 12 within a blanking interval of the video signal generator 16 in accordance with the rewrite information as a pair of the designated color number and the new color data stored temporarily in the buffer.

The counter 21 counts write signals (CPU WRITE) from the CPU 13 and outputs the count to the decoder 22. This counter is necessary when a plurality of rewrite information pairs to be supplied to the color conversion table memory 12 within one blanking interval are present in this temporary storage circuit. The decoder 22 is enabled by the write signal (CPU WRITE) from the CPU 13 and decodes the input count. In accordance with this decoded value, the latch circuits 23A to 23D are enabled in sequence in an order of 23A, 23B, 23C, and 23D. An address bus and a data bus are connected to these latch circuits 23A to 23D. A latch circuit enabled by the decoder 22 latches rewrite information (CPU ADD./DATA) as a pair of a designated color number and new color data transmitted to these buses. Color numbers and color data latched by the latch circuits 23A to 23D are output to the selector 24.

The number of latch circuits is four in this arrangement because it is assumed that the number of rewrite information pairs to be applied to the color conversion table memory 12 within one blanking interval is four or less. If a larger number of rewrite information are available, a corresponding number of latch circuits are needed. The latch circuit may be constituted by a memory.

The selector 24 selects input information to be output on the basis of the output value from the counter 25. The counter 25 is enabled under the control of the counter control circuit 26 which receives a CLOCK signal and an HBLNKN signal. The counter 25 in an enable state counts the input CLOCK signals and outputs the count to the selector 24. The counter 25 is reset by the HBLNKN signal. This HBLNKN signal indicates the retrace interval of a horizontal sync signal of the CRT 18, which is output from the CRT controller 17.

The counter control circuit 26 not only controls the counter 25 but also outputs a write strobe signal (WRITE STRB) signal for determining the write timing with respect to the color conversion table memory 12. Of the color data selected by the selector 24, an address signal is output as an ADDRESS IN signal to the bus switch 27, and a data signal is output as a DATA IN signal to the color conversion table memory 12. In addition to the output from the selector 24, the bus switch 27 receives video memory data (VIDEO MEMORY DATA) from the video memory 11. On the basis of the HBLNKN signal, the bus switch 27 switches from the connection between the video memory 11 and the color conversion table memory 12 to the connection between the selector 24 and the color conversion table memory 12.

For simplicity, the latch circuits for temporarily storing rewrite information are selected in sequence in this arrangement. Originally, however, selection of the latch circuits must be controlled by input/output in accordance with the number of rewrite information pairs present within a single blanking interval.

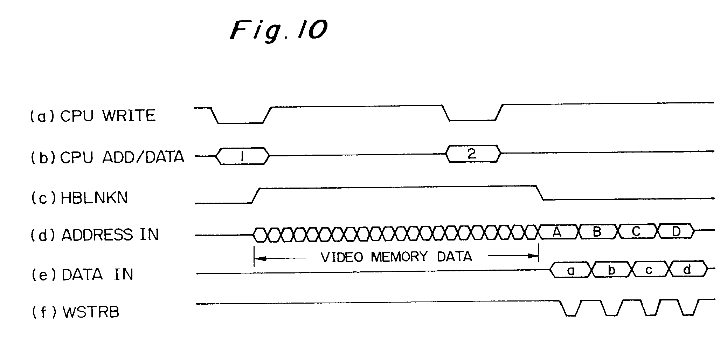

Assume, in this arrangement, that a CPU WRITE signal indicated by a signal (a) in Fig. 10 is input to the transmission path selecting circuit 14, and rewrite information (data 1, data 2) as a pair of a designated new color number and new color data is output from the CPU 13 at a timing indicated by a signal (b) in Fig. 10. This rewrite information as a pair of the designated color number and the new color data is transmitted to the address and data buses, latched by the latch circuits 23A to 23D in sequence in the order named in accordance with the decoded value from the decoder 22, and output to the selector 24. Assume also that an HBLNKN signal changes at a timing indicated by a signal (c) in Fig. 10. When this HBLNKN signal is at level HIGH, video memory data (VIDEO MEMORY DATA) stored in the video memory 11 is output at a timing indicated by a signal (d) in Fig. 10 because the bus switch 27 is connected to the video memory 11 side. Therefore, the color conversion table memory 12 performs color conversion corresponding to the video memory data and outputs the converted color data to the video signal generator 16. The video signal generator 16 D/A-converts this color data, and the CRT 18 performs image display on the basis of the consequent video signal.

When, on the other hand, the HBLNKN signal changes from HIGH to LOW, the bus switch 27 switches from the video memory 11 side to the selector 24 side. Therefore, the color number as the address signal from the selector 24 is output to the color conversion table memory 12, and the stored content at a storage location designated by this address is replaced by new color data. That is, when the HBLNKN signal goes LOW, rewrite information as pairs of the designated color numbers and the new color data latched by the latch circuits 23A, 23B, 23C, and 23D are output to the color conversion table memory 12 in sequence in the order named. This address output as the designated color number is represented by an ADDRESS IN signal indicated by a signal (d) in Fig. 10; when the HBLNKN signal is at LOW, addresses A to D corresponding to the outputs from the latch circuits 23A to 23D are generated. The new color data to be applied to the color conversion table memory 12 is represented by a DATA IN signal indicated by a signal (e) in Fig. 10; the signal is output as data a to d from the selector 24 to the color conversion table memory 12. As a result, the color numbers stored at the addresses A to D of the color conversion table memory 12 are rewritten by the data a to d as the new color data at the LOW timings of a write strobe signal (WSTRB) indicated by a signal (f) in Fig. 10.

According to this embodiment as described above, since the latch circuits 23A to 23D temporarily store the rewrite information (addresses A to D, data a to d) as pairs of designated color numbers and new color data, the CPU 13 can write the rewrite information at an arbitrary timing; the CPU 13 need not wait until a display time elapses unlike in conventional systems. This eliminates an idle time in the CPU operation and consequently allows a high-speed display of a large quantity of information. In addition, the new rewrite information written in the latch circuits 23A to 23D are read out to change the stored contents of the color conversion table memory 12 within the blanking interval of the video signal generator 16 during which the HBLNKN signal is at level LOW. Hence, the CPU 13 does not access the color conversion table memory 12 within the display time unlike in conventional systems, and this prevents occurrence of flash on the screen. Furthermore, since the apparatus is realized without using any expensive, large-capacity dual port memory, there is provided an inexpensive information display apparatus.

Note that the number of bits of each of the counters 21 and 25 and the number of parallel latch circuits 23 are determined by the operating speed of the CPU 13 and the access time of the CPU 13 with respect to the color conversion table memory 12. Therefore, by changing the number of bits or the number of parallel latch stages, the present invention becomes applicable to various types of CPUs or color conversion table memories.

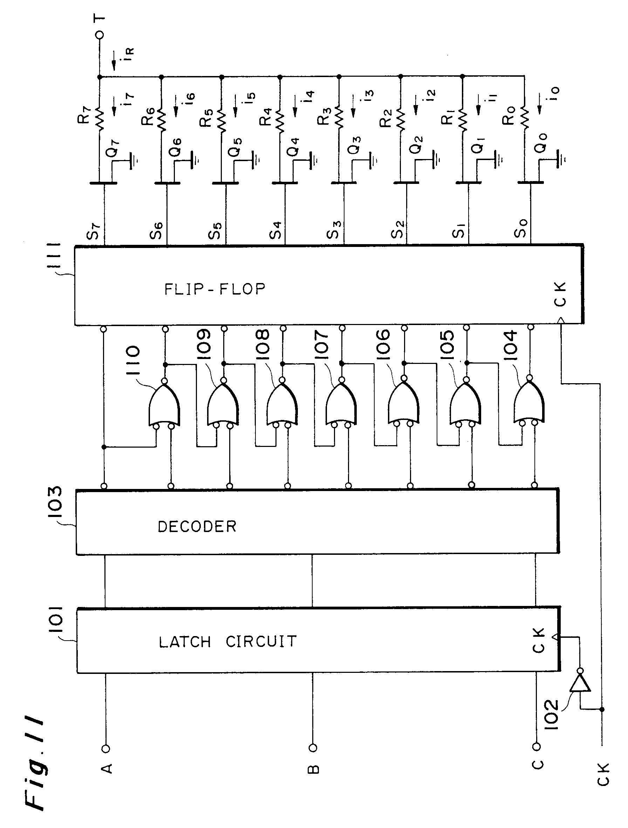

Fig. 11 is a circuit diagram showing an internal DAC of the video signal generator 16. This DAC is a part of the video signal generator 16 for digital-to-analog-converting color data as a digital value from the color conversion table memory 12 into a video signal in order to display the color data on the CRT 18.

A latch circuit 101 latches 3-bit digital signals A, B, and C as objects of D/A conversion. The latch timing is determined by a clock signal CK inverted by a NOT gate 102 and input from a clock terminal ck. The latched digital signals are transferred to a decoder 103, and the decoder 103 decodes the input digital signals. That is, the decoder 103 obtains a one-to-one correspondence between a code specified by the input 3-bit digital signals and one of numeric values 0 to 7, and outputs a digital signal of level LOW from one of output terminals O₀ to O₇ corresponding to that numeric value. One input terminal of each of AND gates 104 to 110 is connected to a corresponding one of the output terminals O₀ to O₆ of the decoder 103. The other input terminals of the AND gates 104 to 109 are connected to the output terminals of the respective adjacent AND gates 105 to 110. The other input terminal of the AND gate 110 is connected to the output terminal O₇ of the decoder 103. The outputs from these AND gates 104 to 110 and the output from the terminal O₇ are supplied to an 8-bit flip-flop 111.

The flip-flop 111 outputs inverted signals of input signals in synchronism with the timing of the clock signal CK input to a clock terminal ck. Output signals S₀ to S₇ from the flip-flop 111 are supplied to the gates of NMOS transistors Q₀ to Q₇, respectively. These transistors Q₀ to Q₇ are connected in parallel between an analog output terminal T and ground via resistors R₀ to R₇, respectively. Since the resistances of these resistors R₀ to R₇ are set equal to one another, an analog output value is equally divided when the transistors Q₀ to Q₇ operate simultaneously. That is, a predetermined voltage is applied to the analog output terminal T, and a current obtained by equally dividing a maximum current I_{R} of the analog output into eight portions flows through each of the transistors Q₀ to Q₇.

The latch circuit 101, the decoder 103, the AND gates 104 to 110, and the flip-flop 111 constitute switch group driving means for driving a predetermined number of adjacent transistors of the transistors Q₀ to Q₇ in accordance with input digital signals.

In this case, "driving adjacent transistors" means that when the number of ON switches is to be increased, OFF switches are turned on without turning off ON switches, thereby increasing the number of ON switches, and, when the number of ON switches is to be decreased, ON switches are turned off without turning on OFF switches, thereby decreasing the number of ON switches.

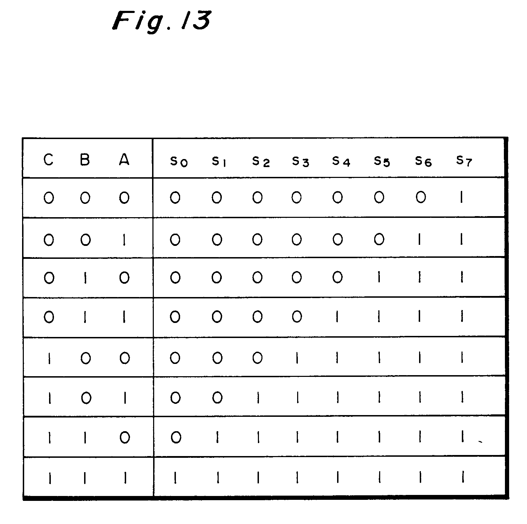

More specifically, transistors, which are turned on simultaneously, are always adjacent consecutive transistors Q₀ to Qₙ (0 ≦ n ≦ 7), and those to be turned off are the remaining transistors Qₙ to Q₇. This switch group driving means forms a predetermined pattern signal as follows. That is, the output signals S₀ to S₇ from the flip-flop 111 are converted into values shown in Fig. 13 in accordance with the input digital signals A, B, and C to the latch circuit 101.

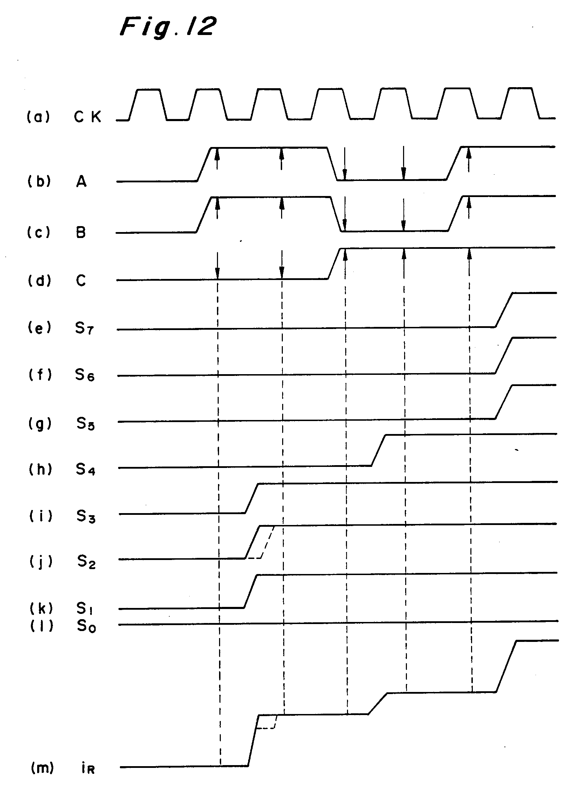

Suppose, in this arrangement, that the clock signal CK is generated at a timing indicated by a signal (a) in Fig. 12, and digital signals A, B, and C indicated by signals (b), (c), and (d) in Fig. 12, respectively, are input to the latch circuit 101. These input digital signals A, B, and C are latched at the timings of the trailing edges of the clock signal CK (timings indicated by arrows in Fig. 12) and output to the decoder 103. Although the latch timing is determined by the leading edge of an input signal to the clock terminal ck of the latch circuit 101, the inverted signal of the clock signal CK is applied to the clock terminal ck, so the input digital signals are latched in synchronism with the trailing edge of the clock signal CK. These 3-bit input digital signals A, B, and C are decoded into a numeric value from 0 to 7 by the decoder 103. In this embodiment, since the input digital signals (C,B,A) changes as (0,0,0), (0,1,1), (1,0,0), and (1,1,1) as shown in Fig. 13, the decoded value of the decoder 103 changes as 0, 3, 4, and 7. When the decoded value is 0, only the output terminal O₀ is set at level LOW, whereas the other output terminals are set at level HIGH. Likewise, when the decoded values are 3, 4, and 7, the output terminals O₃, O₄, and O₇ are set at level LOW, respectively, and the other output terminals are set at level HIGH.

The AND gates 104 to 110 are grouped in accordance with the output value from the decoder 103, and a group of a predetermined number of adjacent AND gates is driven. That is, an AND gate applied with a signal of level LOW outputs an output of level LOW, and the next AND gate applied with that output also outputs an output of level LOW. In this embodiment, if the decoded value is 0, the output from only the AND gate 104 connected to the output terminal O₀ goes LOW. If the decoded value is 3, the output from the AND gate 107 connected to the output terminal O₃ goes LOW, and subsequently the outputs from the AND gates 106, 105, and 104 located below the AND gate 104 in Fig. 11 go LOW. Consequently, the AND gates 104 to 110 are divided into two groups with reference to the AND gate 107 as a boundary. The AND gates 104 to 110 similarly operate for decoded values of 104 and 107.

The flip-flop 111 generates inverted signals of the output signals from the AND gates 104 to 110 and the terminal O₇ in synchronism with the clock signal CK. Although the latch timing of the latch circuit 101 is determined by the trailing edge of the clock signal CK, the state change timing of the flip-flop 111 is determined by the leading edge of the clock signal CK. For this reason, the state change timing of the flip-flop 111 delays from the latch timing of the latch circuit 101 by one clock signal. This delay ensures a time required for the decoder 103 and the AND gates 104 to 110 to perform decoding. In addition, since the output signals from the AND gates 104 to 110 are divided into two groups as described above, the output signals S₀ to S₇ from the flip-flop 111 are patterned as shown in Fig. 13 in accordance with the input digital signals. Here again, therefore, when the input digital signals (C,B,A) are (0,0,0), the output signal S₀ goes HIGH, while the output signals S₁ to S₇ go LOW; when the input digital signals (C,B,A) are (0,1,1), the output signals S₀ to S₃ go HIGH, while the output signals S₄ to S₇ go LOW. Similarly, the output signals are converted into output signal patterns according to Fig. 13 with respect to the other input digital signals. As a result, the output signals S₇ to S₀ cause state changes indicated by signals (e) to (ℓ) in Fig. 12 in accordance with the input digital signals A, B, and C.

The transistors Q₀ to Q₇ are driven by these patterned signals; a predetermined number of adjacent transistors are driven in accordance with grouping of the AND gates 104 to 110, and a current i_{R} indicated by a signal (m) in Fig. 12 corresponding to the sum total of currents flowing through the individual transistors appears at the analog output terminal T. In this embodiment, if the input digital signals (C,B,A) are (0,0,0), a current i₀ flowing through the transistor Q₀ driven by the output signal S₀ directly flows as the current i_{R}. In the case of the input digital signals (0,1,1), shunt currents i₀ to i₃ flowing through the transistors Q₀ to Q₃ driven by the output signals S₀ to S₃ are integrated, and the consequent integrated current flows as the current i_{R}. Likewise, for the other input digital signals, shunt currents i₀ to i₇ flowing through the individual transistors are integrated in correspondence with the input digital signals, and the result of integration flows as the current i_{R}. The input digital signals A, B, and C are D/A-converted into analog values in accordance with increase/decrease in the current i_{R} corresponding to the values of the input digital signals.

According to this embodiment as described above, the maximum current I_{R} of an analog output is equally divided by the transistors Q₀ to Q₇, and the individual equal shunt currents i₀ to i₇ are arbitrarily integrated and converted into an analog output, i.e., the current i_{R} corresponding to the input digital values. Therefore, even if the shunt currents i₀ to i₇ more or less vary due to variations in resistances of the resistors R₀ to R₇, a variation in sum total of these variations in the shunt currents i₀ to i₇ is extremely small. Accordingly, a variation in the current i_{R} corresponding to the sum of these shunt currents i₀ to i₇ is also very small. This consequently makes it possible to perform accurate D/A conversion and prevents reduction in precision of the D/A conversion even if the number of bits to be converted increases.

In addition, as described above, adjacent consecutive transistors Q₀ to Qₙ (0 ≦ n ≦ 7) always operate at the same time, and the current i_{R} as the analog output is obtained by sequentially integrating the shunt currents flowing through these transistors. As an example, when the input digital signals (C,B,A) change from (0,0,0) to (0,1,1), the shunt currents i₁ to i₃ are integrated in sequence with the shunt current i₀ to yield the current i_{R}. For this reason, even if the operation of a given transistor delays, no large reduction is produced in the current i_{R} as the sum total of the individual shunt currents. For example, even if the operation of the transistor Q₂ delays and the transistor changes to an ON state at a timing indicated by a broken line of the signal (j) in Fig. 12, the resulting waveform of the current i_{R} changes into are, as indicated by a broken line of the signal (m) in Fig. 12.

That is, a glitch as indicated by the signal (b) in Fig. 7 according to the prior art does not occur in the analog output. This is so because a delay takes place only in integration of the shunt current i₂ with the integrated value of the shunt currents i₀, i₁, and i₃; that is, a current i_{R}n (0 < n ≦ 7) obtained for a decoded value n is larger than a current i_{Rn-1} in any case. This makes it unnecessary to take special care in fabrication of transistors so that the transistors operate equally, unlike in conventional systems.

Furthermore, since the analog output is equally divided, shunt current quantities that the individual transistors Q₀ to Q₇ bear are small. Therefore, MOS transistors can be used as these transistors as in this embodiment, and this makes feasible an inexpensive DAC having a high packing density and consuming little power.

Note that the above embodiment has been explained by taking the circuit for D/A-converting 3-bit digital signals as an example for simplicity. However, the present invention is similarly applicable to circuits for D/A-converting digital signals of 8 bits, 16 bits, and the like. For example, in order to perform D/A conversion for 8-bit digital signals, 256 MOS transistors are connected in parallel with the analog output terminal in the same circuit configuration as the above embodiment, and the same effects as the above embodiment are obtained.

Note also that in the above embodiment, the analog output is a current and is equally divided by the resistors R₀ to R₇. However, the analog output is not limited to a current. As an example, the analog output may be a magnetic force and equally divided by an inductance. More specifically, it is possible to connect coils with the same number of turns in series with the transistors Q₀ to Q₇ and equally divide an output magnetic force, thereby converting input digital signals into a quantity of magnetic force. The application of this circuit can also realize a magnetic circuit (digital direct coil). It is also possible to convert the analog output into a quantity of light. In any case, the same effects as the above embodiment can be obtained.

In addition, in the above embodiment, the transistor Q₀ is allowed to operate even if all the input digital signals A, B, and C are 0s. However, all the transistors may be turned off if necessary. That is, optimal D/A conversion can be performed in accordance with a circuit of an intended application.

Furthermore, the output signals from the color conversion table memory 12 are decoded in the above embodiment. However, a decoder may be arranged in a color data input unit of the color conversion table memory 12 to decode an input signal to the color conversion table memory 12, and this decoded value may be stored as color data in the color conversion table memory 12. This requires a larger memory capacity in the color conversion table memory 12, but the time required from signal output from the color conversion table memory 12 to image display on the CRT 18 can be shortened. Industrial Applicability

According to the present invention as has been described above, since rewrite information as a pair of a color number and new color data is temporarily stored in a buffer, a CPU can perform write processing at an arbitrary timing. In addition, the rewrite information as a pair of the new color number and the new color data written in the buffer is read out to change the contents of color conversion table storage means within a blanking interval of display means. Hence, there is provided a color information processing apparatus excellent in high-speed performance of information display processing, free from flash, and inexpensive.

An analog output is equally divided by switches constituting output means, and the equally divided analog quantities, i.e., the outputs from the individual switches are integrated and converted into an analog output corresponding to input digital values. Therefore, even if the outputs from the individual switches more or less vary due to variations in resistances or the like, a variation in sum total of the variations in outputs from the switches is extremely small. As a result, a variation in analog output corresponding to the sum total of the equal divisional quantities, i.e., the sum total of the outputs from the individual switches is also very small. This enables accurate D/A conversion and prevents a reduction in precision of the D/A conversion even if the number of bits to be converted increases.

In addition, the swishes operate under the control such that when the number of ON switches is to be increased, OFF switches are turned on without turning off ON switches, and, when the number of ON switches is to be decreased, ON switches are turned off without turning on OFF switches. The outputs from the individual switches are integrated to yield an analog output. Therefore, even if the operations of the switches delay, this does not result in a large increase or decrease in the sum total of the outputs from the individual switches, i.e., the analog output. This eliminates occurrence of a glitch in analog output and consequently realizes a DAC with a high operating speed. This also makes it unnecessary to take special care in fabrication of the switches in order to prevent a glitch.

Furthermore, since the analog output is equally divided, divisional analog quantities that the individual switches bear are small. Therefore, MOS transistors can be used as these switches.

The present invention is also an information processing system, in which the output means, the switch control means, the color conversion table storage means, and the temporary storage means, all described above, are formed on a single semiconductor chip, and which further comprises a CPU. As a result, there can be provided an information processing system using the color information processing apparatus and the digital-to-analog converter excellent in high-speed performance of information display processing, free from flash, and inexpensive.

## Claims

1. A color information processing apparatus comprising:
image information storage means for storing image information as color numbers;
color conversion table storage means for storing color data corresponding to the color numbers and outputting color data corresponding to a color number read out from said image information storage means to display means;
temporary storage means for temporarily storing rewrite information as a pair of a rewrite color number and rewrite color data for rewriting the color data stored in said color conversion table storage means; and
color conversion table rewriting means for rewriting the color data stored in said color conversion table storage means within a blanking interval of said display means in accordance with the rewrite information stored in said temporary storage means.

2. An apparatus according to claim 1, wherein said display means performs image display by a raster scan scheme.

3. An apparatus according to claim 1, wherein said temporary storage means includes
a storage element group constituted by a plurality of storage elements, and
selecting means for selecting said storage elements,
each of said storage elements stores the rewrite information, and
when a plurality of rewrite information pairs to be output to said color conversion table storage means within a single blanking interval are present in said storage element group, said selecting means selects said storage elements for each input or output of said storage element group.

4. An apparatus according to claim 3, wherein said storage element is constituted by a latch circuit.

5. An apparatus according to claim 1, wherein said color conversion table rewriting means includes a switching circuit for switching a connection between said image information storage means and said color conversion table storage means to a connection between said temporary storage means and said color conversion table storage means.

6. An apparatus according to claim 1, wherein said color conversion table storage means, said temporary storage means, and said color conversion table rewriting means are formed on a single semiconductor chip.

7. An image display apparatus comprising:
display means for displaying information as an image;
image information storage means for storing image information as color numbers;
color conversion table storage means for storing color data corresponding to the color numbers and outputting color data corresponding to a color number read out from said image information storage means to display means;
temporary storage means for temporarily storing rewrite information as a pair of a rewrite color number and rewrite color data for rewriting the color data stored in said color conversion table storage means; and
color conversion table rewriting means for rewriting the color data stored in said color conversion table storage means within a blanking interval of said display means in accordance with the rewrite information stored in said temporary storage means.

8. An information processing apparatus comprising: data input means;
a CPU for processing data from said data input means to produce image information;
display means for displaying information as an image;
image information storage means for storing the image information as color numbers;
color conversion table storage means for storing color data corresponding to the color numbers and outputting color data corresponding to a color number read out from said image information storage means to display means;
temporary storage means for temporarily storing rewrite information as a pair of a rewrite color number and rewrite color data for rewriting the color data stored in said color conversion table storage means; and
color conversion table rewriting means for rewriting the color data stored in said color conversion table storage means within a blanking interval of said display means in accordance with the rewrite information stored in said temporary storage means,
wherein said CPU controls each of said means.

9. A digital-to-analog converter comprising:
output means having a plurality of switches commonly connected in parallel with a common output terminal; and
switch control means for controlling said switches,
wherein each of said switches has an element for controlling a current flowing through said switch in correspondence with ON/OFF, and
said switch control means performs control in correspondence with the input digital value such that when the number of ON switches is to be increased, OFF switches are turned on without turning off ON switches, thereby increasing the number of ON switches, and, when the number of ON switches is to be decreased, ON switches are turned off without turning on OFF switches, thereby decreasing the number of ON switches.

10. A converter according to claim 9, wherein values of currents flowing through said switches in an ON state substantially equal each other.

11. A converter according to claim 10, wherein said switch control means includes
a decoder unit, having a plurality of decoder output terminals, for outputting a signal to one of said decoder output terminals in correspondence with an input digital value, and
a logic circuit, having logic circuit output terminals in a number corresponding to the number of said switches, for outputting a signal to said logic circuit output terminals in a number corresponding to the number of said decoder output terminals.

12. A converter according to claim 10, wherein said output means and said switch control means are formed on a single semiconductor chip.

13. A color information processing apparatus comprising:
image information storage means for storing image information as color numbers;
color conversion table storage means for storing color data corresponding to the color numbers and outputting color data corresponding to a color number read out from said image information storage means to display means;
temporary storage means for temporarily storing rewrite information as a pair of a rewrite color number and rewrite color data for rewriting the color data stored in said color conversion table storage means; and
color conversion table rewriting means for rewriting the color data stored in said color conversion table storage means within a blanking interval of said display means in accordance with the rewrite information stored in said temporary storage means,
wherein said display means includes a digital-to-analog converter,
said digital-to-analog converter includes output means having a plurality of switches commonly connected in parallel with a common output terminal, and
switch control means for controlling said switches,
each of said switches has an element for controlling a current flowing through said switch in correspondence with ON/OFF, and
said switch control means performs control in correspondence with the input digital value such that when the number of ON switches is to be increased, OFF switches are turned on without turning off ON switches, thereby increasing the number of ON switches, and, when the number of ON switches is to be decreased, ON switches are turned off without turning on OFF switches, thereby decreasing the number of ON switches.

14. An image display apparatus comprising:
display means for displaying information as an image;
image information storage means for storing image information as color numbers;
color conversion table storage means for storing color data corresponding to the color numbers and outputting color data corresponding to a color number read out from said image information storage means to display means;
temporary storage means for temporarily storing rewrite information as a pair of a rewrite color number and rewrite color data for rewriting the color data stored in said color conversion table storage means; and
color conversion table rewriting means for rewriting the color data stored in said color conversion table storage means within a blanking interval of said display means in accordance with the rewrite information stored in said temporary storage means,
wherein said display means includes a digital-to-analog converter,
said digital-to-analog converter includes output means having a plurality of switches commonly connected in parallel with a common output terminal, and
switch control means for controlling said switches,
each of said switches has an element for controlling a current flowing through said switch in correspondence with ON/OFF, and
said switch control means performs control in correspondence with the input digital value such that when the number of ON switches is to be increased, OFF switches are turned on without turning off ON switches, thereby increasing the number of ON switches, and, when the number of ON switches is to be decreased, ON switches are turned off without turning on OFF switches, thereby decreasing the number of ON switches.

15. An information processing apparatus comprising:
data input means;
a CPU for processing data from said data input means to produce image information;
display means for displaying information as an image;
image information storage means for storing the image information as color numbers;
color conversion table storage means for storing color data corresponding to the color numbers and outputting color data corresponding to a color number read out from said image information storage means to display means;
temporary storage means for temporarily storing rewrite information as a pair of a rewrite color number and rewrite color data for rewriting the color data stored in said color conversion table storage means; and
color conversion table rewriting means for rewriting the color data stored in said color conversion table storage means within a blanking interval of said display means in accordance with the rewrite information stored in said temporary storage means,
wherein said CPU controls each of said means,
said display means includes a digital-to-analog converter,
said digital-to-analog converter includes output means having a plurality of switches commonly connected in parallel with a common output terminal, and
switch control means for controlling said switches,
each of said switches has an element for controlling a current flowing through said switch in correspondence with ON/OFF, and
said switch control means performs control in correspondence with the input digital value such that when the number of ON switches is to be increased, OFF switches are turned on without turning off ON switches, thereby increasing the number of ON switches, and, when the number of ON switches is to be decreased, ON switches are turned off without turning on OFF switches, thereby decreasing the number of ON switches.

16. An apparatus according to claim 13, wherein said output means, said switch control means, said color conversion table storage means, and said color conversion table rewriting means are formed on a single semiconductor chip.
